# EUROPÄISCHE PATENTANMELDUNG

(11) **EP 4 835 508 A1**
(43) Veröffentlichungstag der Anmeldung: **04.11.2026**
(21) Anmeldenummer: 25173908.2
(22) Anmeldetag: 02.05.2025
(51) Int. Cl.: G01R 33/48, G01R 33/561

(54) **VERFAHREN UND SYSTEM ZUR UNTERSUCHUNG EINES KÖRPERS MITTELS MAGNETRESONANZTOMOGRAPHIE**

(71) Anmelder: Forschungszentrum Jülich GmbH, 52428 Jülich (DE)
(72) Erfinder: KÜPPERS, Fabian, 41068 Mönchengladbach (DE); SHAH, Nadim Joni, 52428 Jülich (DE); FARRHER, Ezequiel, 52066 Aachen (DE); CHOI, Chang-Hoon, 52428 Jülich (DE)
(74) Vertreter: Gille Hrabal Partnerschaftsgesellschaft mbB Patentanwälte

(57) **Zusammenfassung**

Die Erfindung betrifft ein Verfahren zur Untersuchung eines Körpers mittels Magnetresonanztomographie, eine Verwendung, ein System, ein Computerprogramm und ein computerlesbares Medium. In einem Verfahren zur Untersuchung eines Körpers (1) mittels Magnetresonanztomographie wird Ultraschall auf einen zu untersuchenden Körper (1) zwischen zwei Anregungspulsen (2) zumindest zeitabschnittsweise derart angewandt, dass eine Spin-Gitter-Relaxationszeit (T1) verkürzt wird. So kann die Wartezeit zwischen den zwei Anregungspulsen verkürzt werden, ohne dass die Qualität der nachfolgenden Aufnahme beeinträchtigt wird.

## Beschreibung

Die Erfindung betrifft ein Verfahren zur Untersuchung eines Körpers mittels Magnetresonanztomographie, eine Verwendung, ein System, ein Computerprogramm und ein computerlesbares Medium.

Die Magnetresonanztomographie (MRT) ist ein nicht-invasives bildgebendes Verfahren zur Untersuchung von Körperteilen, bei dem Schnittbilder des Körpers für die medizinische Diagnostik erzeugt werden. Sie beruht auf der resonanten Anregung bestimmter im Körper enthaltener Atomkerne, z. B. Wasserstoff, mittels starker Magnetfelder, die die Induktion eines elektrischen Signals bewirkt. Dabei werden durch präzise getaktete Hochfrequenzimpulse und Magnetfeldgradienten die Ausrichtung und Relaxation des Kernspins der im Gewebe vorhandenen Protonen manipuliert. Auf diese Weise können räumliche, dynamische und chemische Informationen lokalisiert und kodiert werden. Durch MR-Kontraste werden so Strukturen im Gewebe sichtbar. Trotz der Nutzung energiearmer Radiowellen mit Wellenlängen im Meterbereich können auf diese Weise hoch aufgelöste Bilder erzeugt werden.

Eine MRT-Sequenz umfasst typischerweise mehrere Anregungen mit unterschiedlichen Parametern, um unterschiedliche Bilder zu erzeugen. Zwischen den Anregungen werden Wartezeiten (Pausenzeiten) eingeführt, um die Spin-Gitter-Relaxation zu gewährleisten. Bei der Spin-Gitter-Relaxation kehrt die longitudinale Komponente der Kernmagnetisierung nach der Anregung durch die Hochfrequenz-Impulse zurück in ihren Gleichgewichtszustand. Dabei wird Energie zwischen den angeregten Spins und der jeweiligen molekularen Umgebung, die auch als Gitter bezeichnet wird, ausgetauscht. Die Spin-Gitter-Relaxation folgt einer exponentiellen Erholungskurve. Die erreichte Spin-Gitter-Relaxation beschreibt die im Anschluss wieder verfügbare Magnetisierung. Ist die Spin-Gitter-Relaxation nicht vollständig abgeschlossen, kann die nächste Anregung nur eine geringere Magnetisierung erzielen und die Qualität der nachfolgenden Aufnahme sinkt, weil etwa der erreichbare Kontrast verringert ist.

Die Zeit, mit der die Magnetisierung ca. 63% ihres Gleichgewichtswertes wiedererlangt hat, wird als Spin-Gitter-Relaxationszeit T₁ bezeichnet. Der konkrete Wert für T₁ ist abhängig vom untersuchten Gewebe. Flüssigkeiten haben beispielsweise längere T₁-Zeiten als andere Gewebe. Auf der Basis dieser Unterschiede können in Magnetresonanz-(MR-)Bildern T₁-gewichtete Kontraste erzeugt werden. T₁ ist zudem abhängig vom Magnetfeld. Gewebe im Sinne der Erfindung umfasst alle in den zu untersuchenden Volumina vorhandenen Strukturen und Stoffe, wie z. B. Muskeln, Fett, graue Substanz, weiße Substanz und Flüssigkeit wie z. B. Cerebrospinalflüssigkeit (CSF).

Die Wartezeit zwischen Anregungspulsen beträgt ungefähr dem 3- bis 5-fachen von T₁, um eine weitgehende bis (annähernd) vollständige Relaxation der Spins zu gewährleisten. Mit einem Faktor von 5 wird sichergestellt, dass die Magnetisierung zu mehr als 99% wiederhergestellt wird. Um die Wartezeit und damit die Gesamtzeit der durchzuführenden MRT-Sequenz zu verkürzen, werden in der Praxis häufig kürzere Wartezeiten verwendet. Dies stellt einen Kompromiss zwischen Bildqualität und Scandauer dar. Um den Komfort für die Patienten zu verbessern, wird ein gewisser Qualitätsverlust in Kauf genommen. Bei bestimmten Verfahren wie z. B. der flüssigkeitsgedämpften Inversionserholung (engl.: fluid attenuated inversion recovery - FLAIR) treten weitere Verzögerungen durch eine lange Vorpolarisierung, Vorsättigung oder Vorpräparation der Spins und/oder eine lange Wartezeit nach einem Inversionsimpuls auf.

Eine bekannte Technik zur Verringerung der Wartezeit besteht in der Verwendung eines niedrigeren Flip-Winkels des anregenden Hochfrequenz-Pulses. Dies erlaubt ein schnelleres Erreichen des Gleichgewichts der longitudinalen Magnetisierung. Allerdings wird im Gegenzug die MR-Signalintensität verringert und ein niedriger Flip-Winkel führt zu weiteren Nachteilen hinsichtlich des Dynamikbereichs, des Gewebekontrasts und zu ggf. unvollständigen Sättigungs- oder Inversionspulsen.

Ein anderer Ansatz ist die Gabe paramagnetischer Kontrastmittel, z. B. basierend auf Gadolinium, um trotz eigentlich zu kurzer Wartezeit einen ausreichenden Kontrast zu erreichen. Kontrastmittel bergen jedoch immer gewisse Risiken. Auch die Modulation der statischen Magnetfeldstärke während der Messung bietet die Möglichkeit, die Wartezeit zu verkürzen, etwa durch das "Fast Field Cycling". T₁ kann als Funktion des statischen Magnetfelds erfasst werden und so zusätzliche Informationen liefern. Hierzu sind allerdings ein spezieller Magnet, eine spezielle Hardware und längere Scanzeiten erforderlich.

Die oben genannten Merkmale und Definitionen können beliebig mit den unten beschriebenen Aspekten und Ausgestaltungen der Erfindung kombiniert werden.

Die Aufgabe der Erfindung besteht darin, die Wartezeit zwischen Anregungspulsen bei der Magnetresonanztomographie zu verringern. Insbesondere sollen dabei Qualitätseinbußen nachfolgender Aufnahmen vermieden werden.

Die Aufgabe wird gelöst durch das Verfahren nach Anspruch 1 sowie die Verwendung, das System, das Computerprogramm und das computerlesbare Medium gemäß den nebengeordneten Ansprüchen. Vorteilhafte Ausgestaltungen sind in den Unteransprüchen angegeben.

Zur Lösung der Aufgabe dient ein Verfahren zur Untersuchung eines Körpers mittels Magnetresonanztomographie. Zwischen zwei Anregungspulsen wird auf einen zu untersuchenden Körper zumindest zeitabschnittsweise Ultraschall angewandt. Dies erfolgt insbesondere derart, dass eine Spin-Gitter-Relaxationszeit (T₁) verkürzt wird. Insbesondere ist die Spin-Gitter-Relaxationszeit eines Gewebes des untersuchten Körpers und/oder des Gewebes, auf welches Ultraschall angewandt wird, gemeint. Die Verkürzung der Spin-Gitter-Relaxationszeit tritt zumindest in einem Teilvolumen des Körpers, auf den Ultraschall angewandt wird, auf.

Es hat sich gezeigt, dass durch Ultraschall die Interaktion zwischen Spin und Gitter beeinflusst werden kann. Auf diese Weise wird die Spin-Gitter-Relaxationszeit des Gewebes, auf welches Ultraschall angewandt wird, verkürzt. Eine verkürzte Spin-Gitter-Relaxationszeit ermöglicht eine verkürzte Wartezeit zwischen zwei Anregungen. Auf diese Weise kann die Dauer einer MRT-Behandlung verkürzt werden bzw. die mögliche Anzahl von Aufnahmen in einer Zeiteinheit kann erhöht werden, ohne die Qualität der Aufnahmen zu beeinträchtigen. Im Vergleich zu den oben beschriebenen, mit herkömmlichen Verfahren verkürzten Wartezeiten werden das Signal-Rausch-Verhältnis und der Kontrast verbessert. Vorteilhaft ist kein Eingriff in das Magnetresonanztomographiegerät notwendig.

Der Körper kann z. B. ein menschlicher oder tierischer Körper sein.

Insbesondere wird der Körper mit einem ersten Anregungspuls angeregt. Der Anregungspuls kann einen oder mehrere Radiofrequenzpulse enthalten. Es wird zumindest ein Volumen des Körpers mit dem ersten Anregungspuls angeregt. Der Anregungspuls kann einen Radiofrequenzpulspuls enthalten oder ein solcher sein. Der Anregungspuls erfolgt üblicherweise in einem Winkel von 90° zur Erzeugung der größtmöglichen messbaren Magnetisierung. Es können ebenso andere Flip-Winkel verwendet werden. Ein Anregungspuls ist ein Magnetresonanz-Anregungspuls.

Insbesondere wird der Körper anschließend mit einem zweiten Anregungspuls angeregt. Der zweite Anregungspuls kann dem ersten Anregungspuls entsprechen oder unterschiedlich sein. Es wird zumindest ein Volumen des Körpers mit dem zweiten Anregungspuls angeregt. Das Volumen kann ganz oder teilweise dem Volumen entsprechen, welches mit dem ersten Anregungspuls angeregt worden ist, oder unterschiedlich sein. Insbesondere stimmen die Volumina zumindest im Wesentlichen überein.

Insbesondere wird nach dem jeweiligen Anregungspuls und/oder vor Beginn der Anwendung des Ultraschalls ein Signal des Körpers detektiert, typischerweise ein Magnetresonanzsignal. Das Signal resultiert insbesondere aus der Wechselwirkung des Anregungspulses mit dem Körper.

Die Zeit zwischen den Anregungspulsen wird auch als Wiederholungszeit oder Repetitionszeit (T_{R}) bezeichnet. Insbesondere erfolgt zwischen den Anregungspulsen eine Wartezeit. Eine Wartezeit ist eine Zeit, in der keine Anregung erfolgt. Die Wartezeit erfolgt zwischen dem ersten Anregungspuls und dem zweiten Anregungspuls. Es muss allerdings nicht zwingend die gesamte Repetitionszeit als Wartezeit ausgestaltet sein. Insbesondere erfolgt während der Wartezeit keine Detektion von Magnetresonanz-Signalen. Die Anwendung von Ultraschall kann in der Wiederholungszeit erfolgen. Auf diese Weise kann die Wartezeit und damit die gesamte Messzeit reduziert werden.

Es können zwischen dem ersten Anregungspuls und dem Beginn der Wartezeit noch weitere Schritte erfolgen, beispielsweise die oben beschriebene Detektion eines Signals.

Zur Verbesserung des verfügbaren T₁-Kontrastes der gemessenen MR-Bilder kann zusätzlich ein an sich bekannter Inversionspuls, auch als Umkehrpuls bezeichnet, vor dem eigentlichen Anregungspuls benutzt werden. Ein Inversionspuls, beispielsweise im Rahmen einer "Inversion-Recovery-Sequenz", hat den Zweck, ein möglichst hohes T₁-Signal zu erzeugen. Dazu wird ein Puls in einem Winkel zwischen 90°, also senkrecht zur Longitudinalrichtung, und 180°, also vollständig in die entgegengesetzte Richtung gekippt bzw. gedreht, erzeugt. Dies führt dazu, dass die Magnetisierung des Körpers invertiert wird.

Zwischen dem Inversionspuls und dem Anregungspuls kann eine weitere Wartezeit erfolgen, die auch als Inversionszeit (T_{I}) bezeichnet wird. Nach dem Inversionspuls erfolgt bereits T₁-Relaxation. Erfolgt der Anregungspuls erst nach einer bestimmten Inversionszeit T_{I}, haben die unterschiedlichen Gewebe des Körpers unterschiedliche Ausgangsmagnetisierungen, da ihre Erholung nach dem Inversionspuls unterschiedlich schnell erfolgt ist. Die Anwendung von Ultraschall kann in der Inversionszeit erfolgen. Auf diese Weise kann der Kontrast besonders effektiv erhöht werden.

Die Echozeit (T_{E}) ist die Zeit zwischen Anregung und Messung des MR-Signals. In der Echozeit erfolgt insbesondere keine Anregung mit Ultraschall. Insbesondere werden die Repetitionszeit und die Echozeit so gewählt, dass eine T₁-Gewichtung erreicht wird. So werden die untersuchten Gewebe vor allem durch ihre T₁-Relaxationszeit, und weniger durch ihre T₂-Relaxationszeit differenziert. Die Echozeit wird insbesondere kurz gewählt, um eine starke T₁-Gewichtung und eine geringe T₂-Gewichtung zu erreichen. In der Echozeit erfolgt insbesondere keine Ultraschallanwendung.

Beispielsweise beträgt die Wartezeit dem 3- bis 5-fachen von T₁. Dieser Wert kann unverändert bleiben, um eine gleichbleibende Qualität des nachfolgenden Aufnahme zu gewährleisten. Aufgrund der verkürzten T₁ ist jedoch die absolute Wartezeit verkürzt.

Ultraschall wird auf das Gewebe des zu untersuchenden Körpers angewandt. Die Ultraschall-Anwendung erfolgt insbesondere mittels FUS (fokussierter Ultraschall). Dabei wird mittels einer Vielzahl von Ultraschallquellen, die typischerweise gekrümmt und/oder um den zu untersuchenden Körper herum angeordnet sind, und typischerweise einer mit den Ultraschallquellen verbundenen Steuerung gezielt ein bestimmtes Volumen mit Ultraschall bestrahlt. Einzelne Ultraschallquellen werden gleichzeitig und/oder nacheinander angesteuert. Auf diese Weise kann die Zielregion präzise und spezifisch fokussiert werden. Die Steuerung kann in Echtzeit erfolgen.

Insbesondere wird Ultraschall nur auf das mit MRT zu untersuchende Gewebe des Körpers angewandt. Insbesondere wird Ultraschall auf kein anderes als das mit MRT zu untersuchende Gewebe des Körpers angewandt.

Es ist bisher lediglich bekannt, hochintensiven FUS zu verwenden, um Gewebe zu erhitzen und zu zerstören oder bestimmte Gehirnregionen mittels Ultraschall zu stimulieren. Die Kombination von MR-FUS kann dabei genutzt werden, um die Erhitzung des Gewebes bzw. die Stimulationseffizienz zu überwachen und damit den Ultraschall entsprechend zu steuern. Der Einsatz von FUS zur Verbesserung der Magnetresonanztomographie ist dagegen bisher nicht bekannt. Insbesondere beeinflusst die Energie des Ultraschalls die Bewegungsdynamik des Kernspinsystems im MRT auf mechanische Weise. Die internen magnetischen und elektrischen Wechselwirkungen, also die Interaktionen zwischen Spins untereinander und zwischen Spin und Gitter, können beeinflusst werden.

Insbesondere wird zumindest ein Parameter und bevorzugt alle maßgeblichen Parameter des Ultraschalls so eingestellt, dass die Spin-Gitter-Relaxationszeit verkürzt wird. Zudem kann sich durch den Ultraschall auch eine Veränderung es Kontrasts ergeben, wie weiter unten im Detail ausgeführt wird.

In einer Ausgestaltung wird die Spin-Gitter-Relaxationszeit (T₁) um wenigstens 3%, bevorzugt um wenigstens 5%, typischerweise um wenigstens 10%, beispielsweise um wenigstens 15% oder wenigstens 20%, insbesondere um wenigstens 25%, vorteilhafterweise um wenigstens 35%, besonders bevorzugt um wenigstens 40%, weiter bevorzugt um wenigstens 45% und in einem Ausführungsbeispiel um wenigstens 50% verkürzt. Die Verkürzung kann ggf. auch mehr als 55%, mehr als 60% oder mehr als 65% oder 70% betragen. Die Wartezeit kann dann, bei gleichbleibender Qualität der folgenden Aufnahme, ebenfalls um den genannten Faktor verkürzt werden.

Insbesondere wird zumindest ein Parameter, bevorzugt alle maßgeblichen Parameter des Ultraschalls so eingestellt, dass die Spin-Gitter-Relaxationszeit um den angegebene Prozentsatz verkürzt wird.

In einem Beispiel wird die Inversionszeit (T_{I}) um die genannten Prozentsatz verkürzt. Die Inversionszeit ist die Zeit, die zwischen dem Inversionssignal (Inversionspuls, Umkehrpuls), beispielsweise bei 180°, und dem Anregungspuls, beispielsweise bei 90°, vergeht.

In einem Beispiel wird die Wiederholungszeit (T_{R}) um den genannten Prozentsatz verkürzt.

In einer Ausgestaltung erfolgt die Anwendung von Ultraschall derart, dass eine Temperatur des Gewebes, auf welches Ultraschall angewandt wird, eine Temperatur von 50°C, insbesondere von 45°C und bevorzugt von 40°C nicht überschreitet.

Die Temperatur meint die maximale Temperatur, die im Fokuspunkt des Ultraschalls auftritt. Bevorzugt erfolgt die Ultraschall-Anwendung derart, dass keine oder keine signifikante Erwärmung des Gewebes erfolgt. Aufgrund der Wechselwirkung des Ultraschalls mit dem Gewebe, insbesondere im Fokus der Ultraschallquelle(n) lässt sich eine geringfügige Erwärmung allerdings nicht ausschließen.

Die Parameter des Ultraschalls, beispielsweise die Frequenz, die Amplitude und/oder die Pulsdauer, werden insbesondere so gewählt, dass die Temperatur unterhalb der angegebenen Werte bleibt. So werden geringe Temperaturerhöhungen gewährleistet. Eine Schädigung des Gewebes wird verhindert. Insbesondere wird Ultraschall auf gesundes Gewebe angewandt, bevorzugt ausschließlich gesundes Gewebe. Insbesondere werden die Parameter des Ultraschalls so gewählt, dass es zu keiner Gewebeschädigung kommt. Insbesondere werden die Parameter des Ultraschalls so gewählt, dass das Gewebe nicht stimuliert wird. In einer Ausführungsform ist der zu untersuchende Körper kein Gehirn. Eine herkömmliche Stimulierung von Gehirnarealen ist nicht gewünscht.

Parameter der Ultraschallanwendung wie Frequenzen, Impulsdauern und/oder Amplituden können optimiert werden, um gezielt einzelne oder Gruppen von Relaxationsmechanismen anzusprechen. Mit diesen Mechanismen verbundene Korrelationszeiten können gezielt verändert werden.

Typischerweise werden die für ein bestimmtes MRT-System und/oder ein bestimmtes Gewebe geeigneten Werte auf der Grundlage von Erfahrung ermittelt. Grundsätzlich können keine immer gültigen, pauschalen Wertebereiche benannt werden, die notwendig sind, um die Spin-Gitter-Relaxationszeit zu verkürzen, da die konkreten Werte maßgeblich von der MRT-Feldstärke, beispielsweise in Form der Larmorfrequenz, der Gewebezusammensetzung und dem zugrundeliegenden T₁-Relaxationsmechanismus abhängt, wobei letzterer durch die Korrelationszeit beschrieben werden kann. Einzelne Parameter wie z. B. die Frequenz können grundsätzlich dieselben Werte annehmen wie bei einer herkömmlichen MR-FUS, wobei andere Parameter wie z. B. die Amplitude dann entsprechend abweichen, um im Zusammenspiel den gewünschten Effekt der Verkürzung von T₁ zu erreichen, insbesondere ohne wesentliche Erhöhung der Temperatur.

In einer Ausgestaltung wird die Anwendung von Ultraschall mit einer Frequenz von bis zu 300 kHz und/oder oberhalb von 10 MHz durchgeführt.

Insbesondere beträgt die Frequenz des Ultraschalls mindestens 100 kHz oder mindestens 300 kHz, bevorzugt mindestens 500 kHz oder mindestens 750 kHz, vorteilhaft mindestens 1MHz, besonders bevorzugt mindestens 2 MHz oder 5 MHz, in einem Ausführungsbeispiel mindestens 10 MHz oder mindestens 20 MHz, insbesondere mindestens 50 MHz und/oder höchstens 10 MHz, insbesondere höchstens 7.5 MHz, bevorzugt höchstens 5 MHz, besonders bevorzugt höchstens 2.5 MHz, typischerweise höchstens 1 MHz, in einem Ausführungsbeispiel höchstens 750 KHz oder 500 kHz.

Höhere Frequenzen sind grundsätzlich auch möglich. Die Frequenz kann bis zu 500 MHz, insbesondere bis zu 250 MHz oder 100 MHz, bevorzugt bis zu 50 MHz, besonders bevorzugt bis zu 25 MHz oder 15 MHz, typischerweise bis zu 10 MHz betragen.

In einer Ausgestaltung wird die Anwendung von Ultraschall mit einer Amplitude von mindestens 1 W und/oder höchstens 1 kW durchgeführt.

Insbesondere ist die Amplitude des Ultraschalls kleiner als 1 kW, typischerweise höchstens 700 W, insbesondere höchstens 500 W, beispielsweise höchstens 300 W, in einer Ausführungsform höchstens 150 W oder 100 W und in einem Ausführungsbeispiel höchstens 50 W und/oder mindestens 1 W, bevorzugt mindestens 5 W, insbesondere mindestens 10 W, besonders bevorzugt mindestens 50 W, beispielsweise mindestens 100 W, in einer Ausführungsform mindestens 200 W, in einem Ausführungsbeispiel mindestens 350 W.

In einer Ausgestaltung wird die Anwendung von Ultraschall mit einer Intensität von mindestens 1,5 W/cm² und/oder höchstens 800 W/cm² durchgeführt.

Insbesondere ist die Intensität des Ultraschalls mindestens 1,5 W/cm², bevorzugt mindestens 3 W/cm², beispielsweise mindestens 6 W/cm² oder mindestens 10 W/cm², typischerweise mindestens 20 W/cm², in einer Ausführungsform mindestens 50 W/cm², in einem Ausführungsbeispiel mindestens 100 W/cm² und/oder höchstens 800 W/cm², bevorzugt höchstens 600 W/cm² oder höchstens 500 W/cm², insbesondere höchstens 300 W/cm², typischerweise höchstens 200 W/cm² oder höchstens 100 W/cm², in einem Ausführungsbeispiel höchstens 50 W/cm² und in einer Ausführungsform höchstens 30 W/cm². Die Intensität ist insbesondere so gewählt, dass die Temperaturerhöhung im Gewebe gering ist.

In einer Ausgestaltung erfolgt die Anwendung von Ultraschall im gesamten mittels Magnetresonanztomographie untersuchten Volumen des Körpers.

In dieser Ausgestaltung kann die Spin-Gitter-Relaxationszeit - bezogen auf das mittels MRT zu untersuchende Volumen - global verkürzt werden. Auf diese Weise kann sichergestellt werden, dass die Spin-Gitter-Relaxationszeit im gesamten zu untersuchenden Volumen reduziert wird. So wird ein maximaler Kontrast im gesamten MRT-Bild gewährleistet. In Teilvolumen, in dem kein Ultraschall angewandt wird, würde anderenfalls der Kontrast verringert werden. Da - wie weiter unten ausgeführt wird - die Beschleunigung der Spin-Gitter-Relaxationszeit abhängig von der Art des Gewebes ist, ist es allerdings möglich, dass nicht im gesamten Volumen, auf das Ultraschall angewandt wird, eine Verkürzung der Spin-Gitter-Relaxationszeit auftritt. Auch eine Verlängerung der Spin-Gitter-Relaxationszeit ist grundsätzlich möglich.

Insbesondere erfolgt die Anregung mittels des ersten Anregungspulses in dem Volumen. Insbesondere erfolgt die Anregung mittels des zweiten Anregungspulses in dem Volumen.

Insbesondere erfolgt die Anwendung von Ultraschall in im Wesentlichen genau dem mittels MRT zu untersuchenden Volumen. Die Einschränkung "im Wesentlichen" bedeutet, dass aufgrund des Fokuseffektes und der üblicherweise verwendeten Vielzahl an Ultraschallquellen eine geringfügige Wirkung von Ultraschall auf das angrenzende Gewebe möglich ist. Das angrenzende Gewebe wird hierbei allerdings nicht durch die Ultraschallquelle(n) fokussiert.

Neben der genannten, globalen Verkürzung der Spin-Gitter-Relaxationszeit hat die Erfindung ein weiteres Einsatzgebiet, und zwar die lokale Verkürzung der Spin-Gitter-Relaxationszeit.

In einer alternativen Ausgestaltung erfolgt die Anwendung von Ultraschall nur in einem Teilvolumen des mittels Magnetresonanztomographie untersuchten Volumen des Körpers.

Hierdurch kann die Spin-Gitter-Relaxationszeit selektiv nur in einem Teilvolumen verkürzt werden. Es hat sich gezeigt, dass der Kontrast auf diese Weise vielfältig beeinflusst werden kann. Dies beruht darauf, dass die T₁-Relaxation in unterschiedlichen Geweben unterschiedlich auf die Ultraschallanwendung reagiert. Mit anderen Worten ist die Beschleunigung der Spin-Gitter-Relaxationszeit abhängig von der Art des Gewebes.

So kann beispielsweise in einem bestimmten Gewebe gezielt der Kontrast erhöht werden, während der Kontrast in den umgebenden Regionen bzw. Geweben unverändert bleibt. Durch Verkürzung der Wartezeit kann eine weitere Beschleunigung erreicht werden. Beispielsweise kann in einem Gewebe von Interesse der Kontrast durch gezielte Ultraschallanwendung selektiv erhöht werden, während in angrenzenden Regionen, die von geringerem Interesse sind, kein Ultraschall verwendet wird. Durch Verringerung der Wartezeit kann nun in dem Gewebe von Interesse in verkürzter Zeit eine ausreichende Qualität erreicht werden, z. B. eine Qualität wie ohne Ultraschall, während das angrenzende Gewebe mit geringerem SNR aufgrund der reduzierten Wartezeiterfasst wird.

Das zu untersuchende Volumen enthält beispielsweise unterschiedliche Gewebe, die unterschiedlich auf den Ultraschall reagieren und deren T₁ deshalb durch den Ultraschall unterschiedlich beeinflusst wird. Es kann gezielt in einem Teilvolumen, in dem beispielsweise vorrangig ein bestimmtes Gewebe vorliegt, eine Anwendung von Ultraschall erfolgen. Es kann je nach Anforderungen und Einsatzzweck gezielt der Kontrast zwischen zwei Geweben erhöht oder verringert werden.

In einer Ausgestaltung ist für zumindest ein Gewebe des zu untersuchenden Körpers das Produkt aus Larmorfrequenz ω₀ und Korrelationszeit τ_{c} größer als 0,3, bevorzugt größer als 0,5, insbesondere größer als 0,7 oder größer als 0,8 und in einem Ausführungsbeispiel größer als 0,9 oder 0,95. In einer Ausgestaltung ist das Produkt aus Larmorfrequenz ω₀ und Korrelationszeit τ_{c} kleiner als 5, bevorzugt kleiner als 3, insbesondere kleiner als 2 oder kleiner als 1,5 und in einem Ausführungsbeispiel kleiner als 1,3 oder 1,25. In einer Ausführung ist das genannte Produkt kleiner als 1,2 oder als 1,1.

Es hat sich gezeigt, dass ein Produkt aus Larmorfrequenz ω₀ und Korrelationszeit τ_{c}, das möglichst nahe an 1,0 liegt, eine maximale Beschleunigung der Erholung bewirkt. Insbesondere werden die Parameter des Ultraschalls so gewählt, dass in Abhängigkeit des Systems, welche die Larmorfrequenz beeinflusst, und in Abhängigkeit des zu untersuchenden Gewebes, welches die Korrelationszeit beeinflusst, das Produkt möglichst nahe an 1,0 liegt.

In einer Ausgestaltung wird die Anwendung von Ultraschall so ausgeführt wird, dass sich für zumindest ein Gewebe des zu untersuchenden Körpers das Produkt aus Larmorfrequenz ω₀ und Korrelationszeit τ_{c} an 1 annähert. Das heißt, dass das Produkt ohne die Anwendung von Ultraschall weiter von 1 entfernt wäre als mit der Anwendung von Ultraschall. Der Wert W = Produkt - 1 ist ohne Ultraschall größer als mit Ultraschall. Dabei ist es unerheblich, ob das Produkt durch die Anwendung von Ultraschall verringert oder vergrößert wird.

Ein weiterer Aspekt der Erfindung ist eine Verwendung von Ultraschall, um bei der Untersuchung eines Körpers mittels Magnetresonanztomographie die Spin-Gitter-Relaxationszeit T₁ zwischen zwei MR-Anregungspulsen zu verkürzen. Alle Merkmale, Eigenschaften und Vorteile des eingangs beschriebenen Verfahrens können auch für die Verwendung gelten und umgekehrt.

Ein weiterer Aspekt der Erfindung ist ein System, umfassend ein Magnetresonanztomographiegerät zum Untersuchen eines Körpers, eine Ultraschalleinrichtung zum Anwenden von Ultraschall auf den zu untersuchenden Körper oder zumindest ein Teilvolumen des zu untersuchenden Körpers sowie eine Steuerungseinrichtung zur Steuerung der Ultraschalleinrichtung derart, dass eine Spin-Gitter-Relaxationszeit T₁ verkürzt wird.

Die Spin-Gitter-Relaxationszeit des Volumens oder Teilvolumens, auf welches Ultraschall angewandt wird, kann auf diese Weise verkürzt werden. Alle Merkmale, Eigenschaften und Vorteile des eingangs beschriebenen Verfahrens sowie der Verwendung können auch für das System gelten und umgekehrt. Das System kann als Hybridsystem bezeichnet werden, da es die zwei Moden MRT und Ultraschall umfasst.

Ein Magnetresonanztomographiegerät umfasst insbesondere eine oder mehrere Spulen bzw. Antennen zum Senden und zum Empfang von Magnetresonanz-Signalen und ggf. eine Steuerungs- und/oder Auswertungseinheit zum Steuern des Sendens und des Empfangs der Magnetresonanz-Signale und/oder zum Auswerten der empfangenen Signale. Das Magnetresonanztomographiegerät ist insbesondere dazu eingerichtet, eine Aufnahme des zu untersuchenden Körpers, beispielsweise ein Schnittbild, anzufertigen und auszugeben.

Eine Ultraschalleinrichtung umfasst mindestens eine, bevorzugt mehrere Ultraschallquellen. Die Ultraschallquelle(n) sind typischerweise gekrümmt und/oder um den zu untersuchenden Körper herum angeordnet oder anordbar. Eine Steuerung der Ultraschalleinrichtung ist mit jeder Ultraschallquelle verbunden, um gezielte Ultraschallwellen zu erzeugen. Insbesondere ist die Ultraschalleinrichtung so eingerichtet, dass die Tiefe und/oder Zielregion gezielt fokussiert werden können.

In einer Ausgestaltung umfasst die Ultraschalleinrichtung mindestens eine Ultraschallquelle. Insbesondere ist die Ultraschallquelle nicht magnetisch.

Insbesondere ist eine oder sind mehrere Ultraschallquellen an einer oder mehreren Ultraschallsonden angeordnet. Insbesondere sind mehrere Ultraschallquellen an einer Ultraschallsonde angeordnet. Eine Ultraschallsonde kann am zu untersuchenden Körper positioniert und ggf. fixiert werden. Insbesondere ist die Ultraschallquelle, bevorzugt die gesamte Ultraschallsonde nicht magnetisch. Mit anderen Worten sind die verwendeten Komponenten nicht magnetisch. Das ermöglicht, die Ultraschallquelle bzw. die Ultraschallsonde im Magnetfeld bzw. Sichtfeld des Magnetresonanztomographiegeräts zu verwenden.

Ein weiterer Aspekt der Erfindung ist ein Computerprogramm, umfassend Befehle, die bei der Ausführung des Programms durch eine Steuerungseinrichtung eines insbesondere erfindungsgemäßen Systems das System veranlassen, die Ultraschalleinrichtung des Systems derart zu steuern, dass eine Spin-Gitter-Relaxationszeit T₁ verkürzt wird.

Ein weiterer Aspekt der Erfindung ist ein computerlesbares Medium, umfassend Befehle, die bei der Ausführung durch eine Steuerungseinrichtung eines insbesondere erfindungsgemäßen Systems das System veranlassen, die Ultraschalleinrichtung des Systems derart zu steuern, dass eine Spin-Gitter-Relaxationszeit T₁ verkürzt wird.

Alle Merkmale, Eigenschaften und Vorteile des eingangs beschriebenen Verfahrens, der Verwendung und des Systems können auch für das Computerprogramm und/oder das computerlesbare Medium gelten und umgekehrt.

Nachfolgend werden Ausführungsbeispiele der Erfindung auch anhand von Figuren näher erläutert. Merkmale der Ausführungsbeispiele können einzeln oder in einer Mehrzahl mit den beanspruchten Gegenständen kombiniert werden, sofern nichts Gegenteiliges angegeben ist. Die beanspruchten Schutzbereiche sind nicht auf die Ausführungsbeispiele beschränkt.

Es zeigen:
- Figuren 1 bis 3:: die Erholung der longitudinalen Magnetisierung für verschiedene Gewebe über die Zeit,
- Figuren 4 bis 6:: verschiedene MRT-Sequenzen,
- Figuren 7 bis 12:: Spektraldichtefunktionen und zugehörige Spin-Gitter-Relaxationszeiten,
- Figuren 13 bis 15:: verschiedene Ultraschallquellen, sowie
- Figuren 16 bis 19:: verschiedene MRT-Sequenzen und zugehörige Erholungskurven der longitudinalen Magnetisierung.

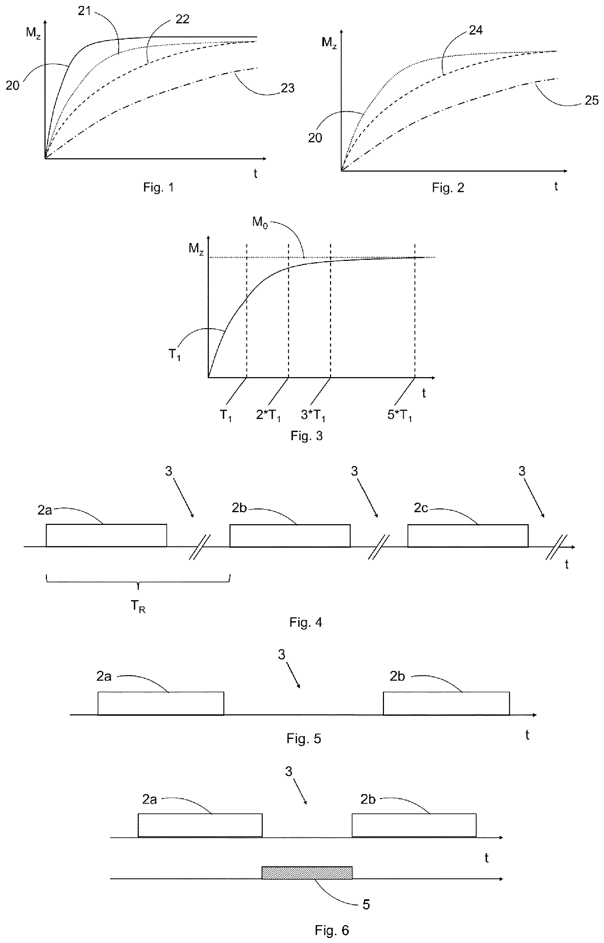

Figur 1 zeigt qualitativ die Erholung der longitudinalen Magnetisierung M_{z} für verschiedene Gewebe, beispielsweise nach einem Anregungspuls, aufgetragen über die Zeit t nach dem Ende des Hochfrequenz-Pulses. Es zeigt sich, dass sich die longitudinale Magnetisierung für Fett 20 am schnellsten erholt, während sich die Kurven für weiße Substanz 21, graue Substanz 22 und Cerebrospinalflüssigkeit 23 jeweils darunter befinden. Jede Kurve ist grundsätzlich exponentiell. Die Erholung erfolgt grundsätzlich nach der Formel ${M}_{Z} = {M}_{0} \left(1-{e}^{- \frac{t}{{T}_{1}}}\right) .$

Dabei bezeichnet M_{z} die longitudinale Magnetisierung zu einem bestimmten Zeitpunkt t nach Abschalten des Hochfrequenz-Pulses, M₀ die Gleichgewichts- bzw. Anfangsmagnetisierung und t die Zeit. Fett 20 hat von den gezeigten Geweben demnach die kürzeste Spin-Gitter-Relaxationszeit T₁.

Figur 2 zeigt in einer ähnlichen Darstellung qualitativ die Erholung von Fett 20 im Vergleich zu Muskeln 24 und Fluid 25.

Figur 3 zeigt ein Beispiel für die Wiederherstellung von M_{z} in Abhängigkeit von der Zeit t. Die Kurve nähert sich exponentiell an die maximal verfügbare longitudinale Magnetisierung an, das der Ausgangsmagnetisierung M₀ entspricht. Es sind als vertikale Linien unterschiedliche Zeitpunkte eingetragen. M_{z} beträgt bei T₁ definitionsgemäß 63% von Mₒ, bei 2*T₁ 86%, bei 3*T₁ 95% und bei 5*T₁ 99%. Der Stern steht in diesem Dokument für eine Multiplikation. Hier sind also die zweifache T₁, die dreifache T₁ usw. dargestellt.

Figur 4 zeigt beispielhaft eine MRT-Sequenz. Zwischen Anregungspulsen 2a, 2b, 2c befinden sich Wartezeiten 3. Der Einfachheit halber sind nur drei Wiederholungen dargestellt, es können aber wesentlich mehr Wiederholungen sein. Es ist sichtbar, dass sich die Wartezeiten 3 über die Dauer der Sequenz addieren und bereits eine kleine Verringerung der Wartezeit eine deutliche Verkürzung der absoluten Dauer der Sequenz ermöglichen kann. Die Wiederholungszeit T_{R} ist die Summe aus der Dauer des jeweiligen Anregungspulses 2 und der Wartezeit 3.

Die Figuren 5 und 6 zeigen schematisch die Wirkung der erfindungsgemäßen Anwendung von Ultraschall 5. Figur 5 zeigt den zeitlichen Ablauf zweier Anregungen 2a, 2b einer herkömmlichen MRT-Sequenz und Figur 6 den zeitlichen Ablauf bei einer erfindungsgemäßen MRT-Sequenz. Durch die auf einer separaten Achse dargestellte Anwendung von Ultraschall 5 kann die Wartezeit 3 signifikant verkürzt werden, im dargestellten Beispiel um ca. 42%. In dieser Ausgestaltung wird die Wiederholungszeit T_{R} reduziert.

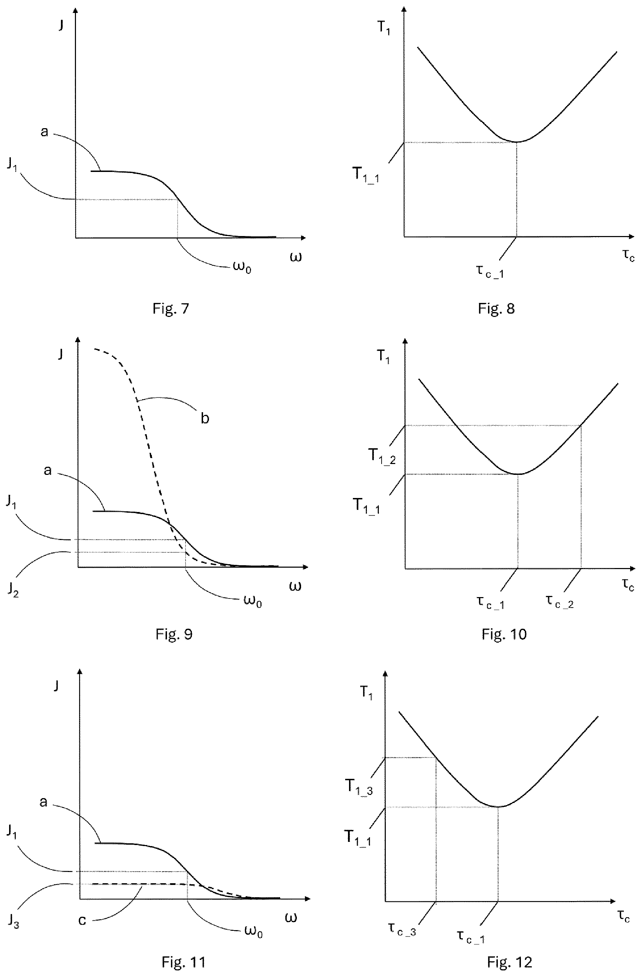

Figur 7 zeigt eine Spektraldichtefunktion J(ω), d. h. eine Fourier-Transformation von Korrelationszeiten. Die Korrelationszeit ist die Zeit, während der die Spins mit dem Gitter wechselwirken, und kann auf unterschiedlichen Mechanismen beruhen. Die Korrelationszeit ist eine gewebespezifische Materialeigenschaft und hängt nicht vom System ab. In dem zu untersuchenden Körper befinden sich typischerweise unterschiedliche Gewebe, die unterschiedliche Korrelationszeiten aufweisen. Flüssigkeitsähnliche Gewebe sind durch schnelle, dynamische Mechanismen gekennzeichnet und weisen kurze Korrelationszeiten τ_{c} auf, während feste oder festkörperähnliche Gewebe sich durch langsamere Mechanismen und längere Korrelationszeiten τ_{c} auszeichnen. Die genannten Mechanismen können je nach Gewebe sehr unterschiedlich sein. In einzelnen Flüssigkeiten kann es sich um Rotations- und Translationsdiffusion handeln, während bei komplexeren Systemen Vibrationen, Freisetzung, molekulardynamische Mechanismen wie z. B. makromolekulare Domänenumorientierungen und strukturelle Undulationen auftreten können.

Demgegenüber hängt die Larmorfrequenz ω₀, also die Frequenz der Präzessionsbewegung des Spins, von der Feldstärke des MRT-Systems ab und ist daher systemabhängig. Die Wirksamkeit der dynamischen Prozesse hängt auch von der Larmorfrequenz ab. Einige Mechanismen, die in einem bestimmten Larmorfrequenzbereich dominant sind, können in anderen Larmorfrequenzbereichen vernachlässigbar sein.

In Figur 7 aufgetragen ist die Spektraldichte J über die Frequenz ω. Bei einer Frequenz ω, die der Larmorfrequenz des MRT-Systems entspricht, liegt eine Spektraldichte J₁ vor. Dargestellt ist ein erstes Beispiel a einer Spektraldichte J eines bestimmten Gewebes in Abhängig der Frequenz ω, und zwar die optimale Spektraldichte J. Bei der dargestellten Kurve gilt: Larmorfrequenz ω₀ * Korrelationszeit τ_{c} ≈ 1 oder = 1, oder anders ausgedrückt: τ_{c} ≈ ω₀⁻¹ bzw. τ_{c} = ω₀⁻¹.

Der Effekt zeigt sich in der damit zusammenhängenden Figur 8, in der die Spin-Gitter-Relaxationszeit T₁ über die Korrelationszeit τ_{c} aufgetragen ist. Der Wert T_{1_1} der Spin-Gitter-Relaxationszeit T₁ hat im Bereich der ersten Korrelationszeit T_{1_1} ein Minimum. Bei der dargestellten optimalen Spektraldichte J wird somit die kürzeste T₁ erreicht. Die Spektraldichte J des ersten Beispiels a ist demnach ein anzustrebender Zielwert. Die gezeigte Kurve, also auch der Ort des Minimums, ist systemabhängig.

In den Figuren 9 und 10 ist - analog zu den Figuren 7 und 8 - zusätzlich zum Beispiel a eine Spektraldichte J eines zweiten Beispiels b gezeigt. Hierbei weicht die Korrelationszeit ab, während die Larmorfrequenz gleich bleibt. Mit anderen Worten wird ein anderes Gewebe im selben System betrachtet.

Im Beispiel b ist eine sehr steile Kurve der Spektraldichte J gezeigt, bei der gilt: ω₀ * τ_{c} << 1 bzw. ω₀ * τ_{c} < 1. Bei Beispiel b kann es sich beispielsweise um die Situation vor Anwendung von Ultraschall handeln. Es zeigt sich, dass bei derselben Larmorfrequenz ω₀ ein kleinerer Wert J₂ der Spektraldichte J vorliegt. Im Diagramm der Figur 10 ist ersichtlich, dass ein größerer Wert der Korrelationszeit τ_{1_2} oberhalb des oben genannten Minimums der Kurve und damit eine längere T_{1_2} auftritt. Durch die Anwendung von Ultraschall kann die Korrelationszeit reduziert werden und so von τ_{c_2} zu τ_{c_1} und damit von T_{1_2} die kürzere T_{1_1} erreicht werden.

Mit anderen Worten: Erfüllt ein dynamischer Mechanismus bei einer gegebenen Larmorfrequenz zunächst die Bedingung ω₀ τ_{c} >> 1 oder ω₀ τ_{c} > 1 in Abwesenheit von Ultraschallwellen (Fig. 9), so kann die entsprechende Korrelationszeit durch die Anwendung der beispielsweise in Frequenz, Pulsdauer und Amplitude optimierten Ultraschallwelle verringert und T₁ reduziert werden (Figur 10).

In den Figuren 11 und 12 ist - analog zu den Figuren 7 und 8 - zusätzlich zum Beispiel a eine Spektraldichte J eines dritten Beispiels c gezeigt. Auch hier weicht die Korrelationszeit ab, während die Larmorfrequenz gleich bleibt.

Im Beispiel c ist eine sehr flache Kurve der Spektraldichte J gezeigt, bei der gilt: ω₀ * τ_{c} >> 1 bzw. ω₀ * τ_{c} > 1. Auch im Beispiel c kann es sich um eine Situation vor einer Anwendung von Ultraschall handeln. Es zeigt sich, dass bei derselben Larmorfrequenz ω₀ ein kleinerer Wert J₃ der Spektraldichte J vorliegt. Im Diagramm der Figur 12 ist ersichtlich, dass ein größerer Wert der Korrelationszeit τ_{1_3} oberhalb des oben genannten Minimums der Kurve und damit eine längere T_{1_3} auftritt. Durch die Anwendung von Ultraschall können wir die Korrelationszeit erhöhen und so von τ_{c_3} zu τ_{c_1} und damit von T_{1_3} zur kürzeren T_{1_1} gelangen

Mit anderen Worten: erfüllt ein dynamischer Mechanismus in Abwesenheit von Ultraschallwellen zunächst die Bedingung ω₀ * τ_{c} >> 1 oder ω₀ * τ_{c} > 1 (Fig. 11), so wird die entsprechende Korrelationszeit durch die Anwendung der insbesondere frequenz- und amplitudenoptimierten Ultraschallwelle erhöht und T₁ ebenfalls verringert (Fig. 12)

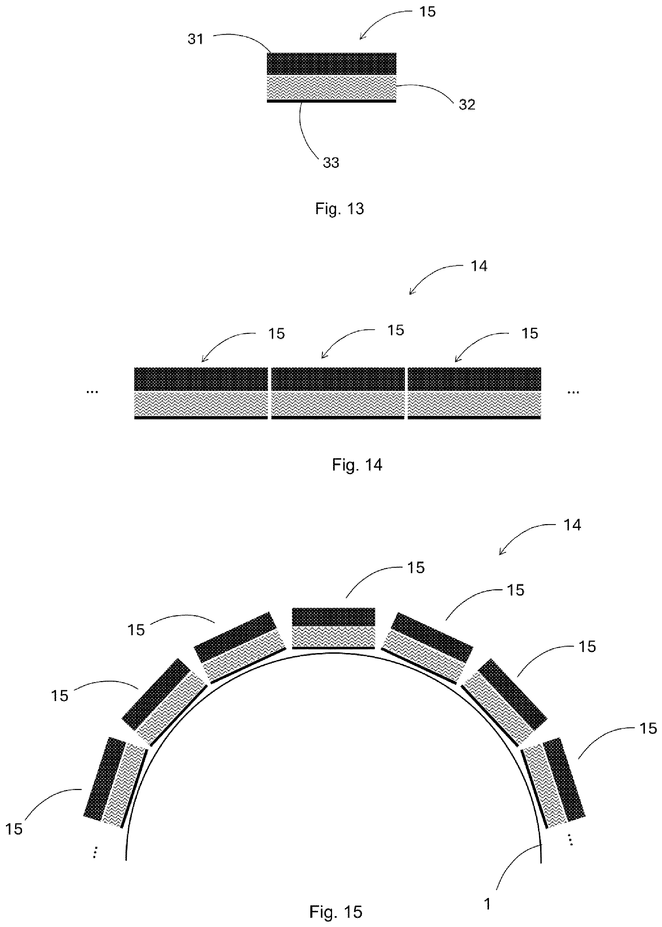

Figur 13 zeigt schematisch eine Seitenansicht oder Schnittzeichnung einer Ultraschallquelle 15 in Form einer FUS-Hochfrequenzspule, umfassend einen Schallkopf 31 und ein optionales Medium 32 bzw. FUS-Medium, insbesondere eine Flüssigkeit wie z. B. Wasser, beispielsweise in Form eines Wasserbeutels. Das Medium 32 transportiert bzw. leitet den Ultraschall möglichst verlustarm zum zu untersuchenden Körper. Der Schallkopf 31 und insbesondere auch die anderen Komponenten 32, 33 sind MRkompatibel, also nicht magnetisch. Die Ultraschallquelle 15 wird so angeordnet, dass die Seite der Hochfrequenzspule 33 zum zu untersuchenden Körper weist und insbesondere an diesem anliegt.

Die Ultraschallquelle 15 kann optional eine MR-Hochfrequenzspule 33 umfassen. Die Spule ist Teil des Magnetresonanztomographiegeräts (MRT-Geräts). Alternativ kann die Spule separat von der Ultraschallquelle 15 angeordnet sein. Die Spule kann dem Senden und/oder dem Empfang hochfrequenter Strahlung dienen. Die Schallkopf 31 bzw. die Ultraschallquelle 15 kann direkt oder indirekt an die MR-Hochfrequenzspule 33 angeschlossen sein. In einem System kann jeder Spule des MRT-Geräts bzw. jedem Kanal eine Ultraschallquelle zugeordnet sein. Spulen bzw. Kanäle des MRT-Geräts können aber auch von den Ultraschallquellen entkoppelt sein.

Figur 14 zeigt eine Ultraschalleinrichtung 14, die mehrere Ultraschallquellen 15 umfasst. Diese sind auf einer virtuellen Geraden angeordnet und haben dieselbe Ausrichtung. Die Ultraschallquellen 15 sind insbesondere wie oben beschrieben aufgebaut. Durch die Punkte an den Seiten ist dargestellt, dass noch mehr Ultraschallquellen 15 vorhanden sein können. Die Ultraschalleinrichtung 14 kann als mehrkanalige beispielsweise eine Ultraschallsonde,

Figur 15 zeigt eine Ultraschalleinrichtung 14, beispielsweise eine Ultraschallsonden, die mehrere Ultraschallquellen 15 umfasst, die auf einer gebogenen Linie angeordnet sind. So können die Ultraschallquellen eng an einem zu untersuchenden Körper 1 wie z. B. dem schematisch dargestellten Kopf eines Patienten angeordnet werden. Die Ultraschallquellen 15 sind insbesondere wie oben beschrieben aufgebaut.

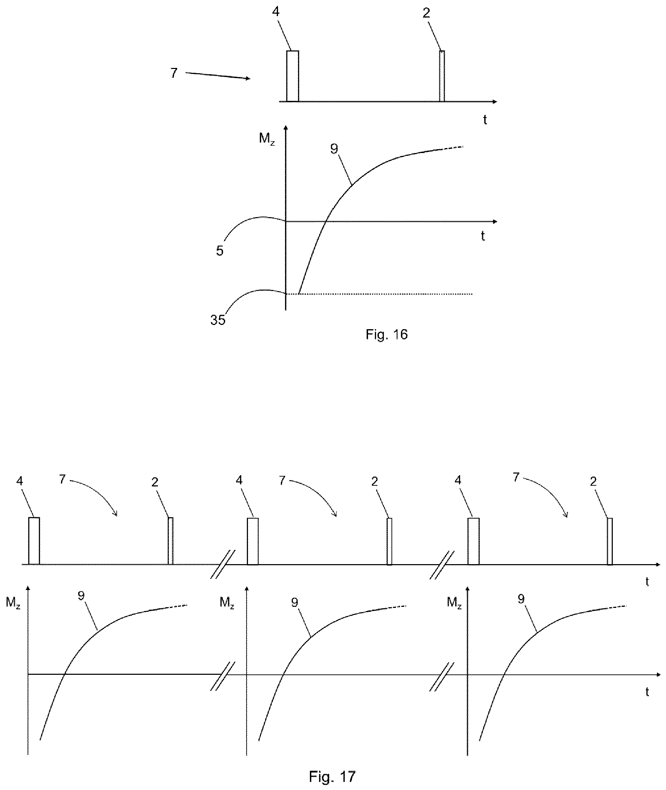

Figur 16 zeigt im oberen Bildteil über die Zeit t aufgetragen eine Sequenz 7, die nacheinander das Inversionssignal 4, auch als Inversionspuls bezeichnet, eine Wartezeit und anschließend das Anregungspuls 2 umfasst. Im unteren Bildteil wird die zugehörige Erholungskurve 9 der longitudinalen Magnetisierung M_{z} über die Zeit t dargestellt. Die gepunktete Linie 35 zeigt den Startpunkt nach Ende des Inversionssignals 4. Dieser ist abhängig vom Flip-Winkel des Inversionssignals 4, der hier zwischen 90° und 180° liegt.

Die Nulllinie 36 zeigt M_{z} = 0. Die Kurve ist demnach unterteilt in einen links dargestellten negativen Teil und einen rechts dargestellten positiven Teil. Der oben rechts gezeigte gestrichelte Fortsatz der Linie zeigt den theoretischen weiteren Verlauf, wenn kein Anregungspuls 2 folgen würde.

Figur 17 zeigt in ähnlicher Weise mehrere aufeinanderfolgenden Sequenzen 7, die wie die Sequenz aus Figur 16 aufgebaut sein können. Gezeigt sind im oberen Bildteil mindestens drei aufeinanderfolgende Inversionssignale und Anregungspulse und entsprechende Wartezeiten und im unteren Bildteil zugehörige Erholungskurven 9 von M_{z}.

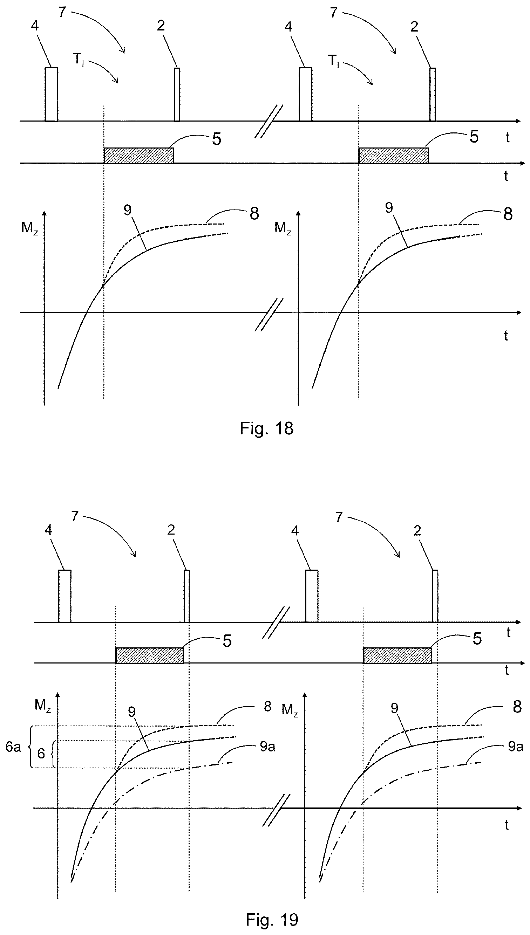

Figur 18 zeigt in einer ähnlichen Abbildung den Effekt 8 von Ultraschall 5 auf Erholungskurven 9 der longitudinalen Magnetisierung M_{z}. Oben sind wieder beispielhaft zwei Sequenzen 7 mit jeweils einem Inversionssignal 4, einer Wartezeit und einem anschließenden Anregungspuls 2 über die Zeit t dargestellt. Beispielsweise beginnt die Anwendung von Ultraschall 5 bei der Nulllinie von M_{z} (vergl. Fig. 16).

Unten dargestellt sind die Erholungskurven 9 von M_{z}. Der Effekt 8 des Ultraschalls 5 ist als gestrichelte Linie eingezeichnet. Es zeigt sich, dass die Erholung von der longitudinalen Magnetisierung M_{z} ab dem Beginn der Anwendung von Ultraschall 5 sichtbar gesteigert werden kann. insgesamt wird so eine deutlich beschleunigte Erholung erreicht. Zum Zeitpunkt des Beginns des Anregungspulses ist M_{z} durch den Effekt 8 des Ultraschalls 5 signifikant höher.

Im hier gezeigten Beispiel wird auf diese Weise die Inversionszeit T_{I} verkürzt, also die Zeit zwischen dem Inversionssignal 4 und dem Anregungspuls 2.

Figur 19 zeigt die Erhöhung des Kontrasts zwischen zwei Geweben. Analog zu Figur 18 sind oben zunächst die zwei Sequenzen 7 und die darin integrierte Anwendung von Ultraschall 5 dargestellt. Unten sind wieder die Erholungskurven 9 von M_{z} und der Effekt 8 des Ultraschalls 5 dargestellt. Anders als im Beispiel 18, in dem idealisiert von einem homogenen Gewebe im untersuchten Körper ausgeht, bezieht sich der in der Kurve 8 gezeigte Effekt im Beispiel der Figur 18 nur auf ein erstes Gewebe des untersuchten Körpers.

Ein zweites Gewebe des Körpers ist anders zusammengesetzt und hat eine andere, nämlich eine längere T₁-Zeit. Das ist in der niedrigeren Erholungskurve 9A sichtbar. Es zeigt sich außerdem, dass das zweite Gewebe anders auf die Anwendung von Ultraschall 5 reagiert, nämlich minimal oder überhaupt nicht. Die Kurve 9A verändert sich durch den Ultraschall 5 nicht. Da die Erholung des ersten Gewebes beschleunigt ist und die Erholung des zweiten Gewebes unverändert niedrig ist, wird durch den Ultraschall 5 zum Zeitpunkt des Anregungspulses 2 (hier beispielhaft am Ende des Anregungspulses 2 eingezeichnet) der Kontrast zwischen den zwei Geweben erhöht. Statt des Kontrasts 6 bewirkt der Ultraschall nun den größeren Kontrast 6a.

Dies ist rein beispielhaft. Es sind in realen Proben üblicherweise mehr als zwei Gewebe vorhanden. Ultraschall kann bei einigen Geweben und/oder bestimmten Parametern auch eine Verlängerung der Erholungszeit bewirken. Es können die Erholungszeiten bestimmter Gewebe gezielt beschleunigt oder verlangsamt werden. Diese Effekte können gleichzeitig erfolgen.

Ein ähnlicher Kontrast wie in Figur 19 könnte sich auch ergeben, wenn beide Gewebe dieselbe T₁-Zeit aufweisen, aber Ultraschall 5 gezielt nur auf das erste Gewebe angewandt wird. Dann würde die Erholung des ersten Gewebes durch den Ultraschall 5 beschleunigt, während die Erholung des zweiten Gewebes nicht vom Ultraschall beeinflusst würde.

**Bezugszeichenliste**

| | |
|---|---|
| Körper | 1 |
| Anregungspuls | 2, 2a, 2b, 2c |
| Wartezeit | 3 |
| Inversionssignal | 4 |
| Ultraschall | 5 |
| Kontrast | |
| Sequenz | 6, 6a 7 9a |
| Effekt | 8 |
| Erholungskurve | 9, |
| System | 10 |
| Magnetresonanzgerät | 12 |
| Ultraschalleinrichtung | 14 |
| Ultraschallquelle | 15 |
| Steuerungseinrichtung | 17 |
| Fett | 20 |
| weiße Substanz | 21 |
| graue Substanz | 22 |
| Cerebrospinalflüssigkeit | 23 |
| Muskel | 24 |
| Fluid | 25 |
| Schallkopf | 31 |
| Medium | 32 |
| MR-Hochfrequenzspule | 33 |
| Gepunktete Linie | 35 |
| Nulllinie | 36 |
| Spin-Gitter-Relaxationszeit | T₁, T_{1_1}, T_{1_2}, T_{1_3}, |
| Zeit | t |
| Wiederholungszeit | T_{R} |
| Inversionszeit | T_{I} |
| Longitudinale Magnetisierung | M_{Z} |
| Ausgangsmagnetisierung | M₀ |
| Spektraldichte | J, J₁, J₂, J₃ |
| erstes Beispiel | a |
| zweites Beispiel | b |
| drittes Beispiel | c |
| Frequenz | ω |
| Larmorfrequenz | ω₀ |
| Korrelationszeit | T_{c}, T_{c_1}, T_{c_2}, T_{c_3} |

## Patentansprüche

1. Verfahren zur Untersuchung eines Körpers (1) mittels Magnetresonanztomographie, bei dem auf einen zu untersuchenden Körper (1) zwischen zwei Anregungspulsen (2) zumindest zeitabschnittsweise Ultraschall (5) derart angewandt wird, dass eine Spin-Gitter-Relaxationszeit (T₁) verkürzt wird.

2. Verfahren nach dem vorhergehenden Anspruch, wobei die Spin-Gitter-Relaxationszeit (T₁) um wenigstens 3%, insbesondere um wenigstens 25% verkürzt wird.

3. Verfahren nach einem der vorhergehenden Ansprüche, wobei die Anwendung von Ultraschall (5) derart erfolgt, dass eine Temperatur des Gewebes, auf welches Ultraschall angewandt wird, einen Wert von 50°C, bevorzugt 40°C nicht überschreitet.

4. Verfahren nach einem der vorhergehenden Ansprüche, wobei die Anwendung von Ultraschall (5) mit einer Frequenz von bis zu 300 kHz oder mehr als 10 MHz durchgeführt wird.

5. Verfahren nach einem der vorhergehenden Ansprüche, wobei die Anwendung von Ultraschall (5) mit einer Amplitude von mindestens 1 W und/oder höchstens 1 kW durchgeführt wird.

6. Verfahren nach einem der vorhergehenden Ansprüche, wobei die Anwendung von Ultraschall (5) mit einer Intensität von mindestens 1,5 W/cm² und/oder höchstens 800 W/cm² durchgeführt wird.

7. Verfahren nach einem der Ansprüche 1 bis 6, wobei, wobei die Anwendung von Ultraschall (5) im gesamten mittels Magnetresonanztomographie untersuchten Volumen des Körpers (1) erfolgt.

8. Verfahren nach einem der Ansprüche 1 bis 6, wobei, wobei die Anwendung von Ultraschall (5) nur in einem Teilvolumen des mittels Magnetresonanztomographie untersuchten Volumen des Körpers (1) erfolgt.

9. Verfahren nach einem der vorhergehenden Ansprüche, wobei für zumindest ein Gewebe des zu untersuchenden Körpers das Produkt aus Larmorfrequenz (ω₀) und Korrelationszeit (τ_{c}) größer ist als 0,5, insbesondere größer als 0,8 und/oder kleiner ist als 2, insbesondere kleiner als 1,3.

10. Verfahren nach einem der vorhergehenden Ansprüche, wobei die Anwendung von Ultraschall (5) so ausgeführt wird, dass sich für zumindest ein Gewebe des zu untersuchenden Körpers das Produkt aus Larmorfrequenz (ω₀) und Korrelationszeit (τ_{c}) an 1 annähert.

11. Verwendung von Ultraschall (5), um bei der Untersuchung eines Körpers (1) mittels Magnetresonanztomographie die Spin-Gitter-Relaxationszeit (T₁) zwischen zwei Anregungspulsen (2) zu verkürzen.

12. System (10), umfassend ein Magnetresonanztomographiegerät (12) zum Untersuchen eines Körpers (1), eine Ultraschalleinrichtung (14) zum Anwenden von Ultraschall (5) auf zumindest ein Teilvolumen des zu untersuchenden Körpers (1) sowie eine Steuerungseinrichtung (17) zur Steuerung der Ultraschalleinrichtung (14) derart, dass eine Spin-Gitter-Relaxationszeit (T₁) verkürzt wird.

13. System nach dem vorhergehenden Anspruch, wobei die Ultraschalleinrichtung (14) mindestens eine Ultraschallquelle (15) umfasst, wobei die Ultraschallquelle (15) nicht magnetisch ist.

14. Computerprogramm, umfassend Befehle, die bei der Ausführung des Programms durch eine Steuerungseinrichtung eines Systems nach Anspruch 12 oder 13 das System veranlassen, die Ultraschalleinrichtung des Systems derart zu steuern, dass eine Spin-Gitter-Relaxationszeit (T₁) verkürzt wird.

15. Computerlesbares Medium, umfassend Befehle, die bei der Ausführung durch eine Steuerungseinrichtung eines Systems nach Anspruch 12 oder 13 das System veranlassen, die Ultraschalleinrichtung des Systems derart zu steuern, dass eine Spin-Gitter-Relaxationszeit (T₁) verkürzt wird.
